# EUROPEAN PATENT APPLICATION

(11) **EP 2 455 173 A2**
(43) Date of publication of application: **23.05.2012**
(21) Application number: 11183920.5
(22) Date of filing: 05.10.2011
(51) Int. Cl.: B23B 51/00, B23B 41/00, B23Q 17/20, B23Q 17/24, H01L 31/20

(54) **Defect repairing tool, defect repairing device and defect repairing method for thin-film solar cell**

(30) Priority: 18.11.2010 JP 2010257434
(71) Applicant: Mitsuboshi Diamond Industrial Co., Ltd., Suita-shi, Osaka 564-0044 (JP)
(72) Inventor: HIRONO, Yoshifumi, Suita-city, Osaka 564-0044 (JP)
(74) Representative: TBK

(57) **Abstract**

A thin-film solar cell defect repairing tool of the present invention is configured to be rotated while being held by a chuck (16) disposed in a head of a processing device for insulating and isolating a local defect caused in a thin-film solar cell. The tool includes a shank (35) and a blade end (36). The shank (35) is formed on an end of the thin-film solar cell and is held by the chuck (16). The blade end (36) is formed on the other end of the thin-film solar cell and includes a blade (36a) for processing on the edge thereof Further, the blade (36a) of the blade end (36) is formed with a predetermined width in a position away from the rotary axis of the tool.

## Description

### BACKGROUND OF THE INVENTION

### Field of the Invention

The present invention relates to a defect repairing tool, particularly to, a defect repairing tool, configured to be rotated while being held by a chuck disposed in a head of a processing device, for insulating and isolating a local defect produced in a thin-film solar cell. Further, the present invention relates to a defect repairing device including the defect repairing tool. Yet further, the present invention relates to a defect repairing method using the defect repairing tool.

### Background Art

The thin-film solar cells (TFSCs) are normally manufactured with methods such as described in Japan Published Utility Model Application No. JP-U-S63-016439. In the manufacturing method of the Application No. JP-U-S63-016439, a lower electrode film made of Mo is formed atop a substrate made of e.g., glass and is then divided into strips. Further, compound semiconductor films, including a compound semiconductor film with a chalcopyrite structure (e.g., a CIGS film), are formed atop the lower electrode film. Yet further, the semiconductor films are partially removed in a stripe shape and divided into strips, and an upper electrode film is formed for covering the processed semiconductor films. Finally, the upper electrode film is partially removed in a stripe shape and divided into strips.

Local defects such as a short circuit between the upper electrode and the lower electrode may be caused in the TFSC manufacturing process due to unwanted incorporation of particles and/or formation of a pinhole in forming the thin films of the TSFC.

In view of the above, methods of repairing such local defects of the TFSCs have been proposed in Japan Laid-open Patent Application Publication No. JP-A-2007-273933 and International Patent Application Publication No. WO2010/023845 A1. Specifically, these publications describe methods of insulating and isolating a defect portion from the rest of a TFSC by means of laser beam.

When a local defect of a TFSC is repaired by means of laser beam as described in the Publications Nos. 2007-273933 and WO2010/023845, melt residue may remains in a laser processed portion. The melt residue may be a cause of a short circuit between the upper electrode and the lower electrode. Thus, another defect may be produced in addition to the original local defect

In view of the above, a countermeasure can be assumed that the local defect portion is removed using a processing tool made of a hard material such as diamond. When a thin film is removed using such a well-known processing tool, however, a relatively wide area of the thin films is removed. Accordingly, the Mo film disposed under the thin films is exposed through the removed area of the thin films. The exposed portion of the Mo film reflects light and shines. Therefore, the aesthetic appearance of the TFSC is deteriorated when externally observed.

The present invention addresses a need to repair a local defect of a TFSC without deteriorating the aesthetic appearance of the TFSC.

### SUMMARY OF THE INVENTION

A thin-film solar cell defect repairing tool according to a first aspect of the present invention is configured to be rotated while being held by a chuck disposed in a head of a processing device for insulating and isolating a local defect caused in a thin-film solar cell. The thin-film solar cell defect repairing tool includes a shank and a blade end. The shank is formed on one end of the thin-film solar cell defect repairing tool and is held by the chuck. The blade end is formed on the other end of the thin-film solar cell defect repairing tool and includes a blade for processing on an edge thereof Further, the blade is formed at a predetermined width in a position away from a rotary axis of the thin-film solar cell defect repairing tool.

In using the thin-film solar cell defect repairing tool, the rotary axis of the thin-film solar cell defect repairing tool is aligned with the local defect caused in the thin-film solar cell. Under the condition, the thin-film solar cell defect repairing tool is rotated while the blade is pressed onto the surface of the cell (i.e., substrate). The thin film is thereby partially removed about the local defect. Consequently, the local defect is insulated and isolated from the other part of the thin film.

According to the first aspect of the present invention, the thin film is partially removed about the local defect in a ring shape. In other words, a region of the thin film, including the local defect, is not entirely removed. Therefore, an electrode film (e.g., a Mo film), disposed under the thin film, is less exposed through the removed portion of the thin film. This can inhibit deterioration of the aesthetic appearance of the thin-film solar cell as much as possible.

A thin-film solar cell defect repairing tool of a second aspect of the present invention relates to the thin-film cell defect repairing tool of the first aspect of the present invention. In the thin-film solar cell defect repairing tool, the blade of the blade end is arranged perpendicularly to the rotary axis of the thin-film solar cell defect repairing tool. Further, the other part of the edge of the blade end excluding the blade is tilted for getting closer to the shank in proportion to distance away from the blade.

According to the thin-film solar cell defect repairing tool of the second aspect of the present invention, the other part of the edge of the blade end, excluding the blade, is tilted for gradually separating away from the blade. Therefore, the strength of the blade is further enhanced than that of a blade protruded from the entire edge of the blade end. Therefore, it is possible to inhibit the blade from being bent or damaged in processing of the thin-film solar cell.

A thin-film solar cell defect repairing tool according to a third aspect of the present invention relates to the thin-film solar cell defect repairing tool according to one of the first and second aspects of the present invention. In the thin-film solar cell defect repairing tool, the blade of the blade end has a width of 0.1 mm or less.

According to the thin-film solar cell defect repairing tool of the third aspect of the present invention, the blade has a width of 0.1 mm or less. In other words, the part of the thin film, removed in a ring shape, has a width of up to 0.1 mm. Therefore, the electrode film, disposed under the thin film, is less exposed through the removed portion of the thin film.

A thin-film solar cell defect repairing device according to a fourth aspect of the present invention is configured to insulate and isolate a local defect caused in a thin-film solar cell. The thin-film solar cell defect repairing device includes a table, a head and a moving mechanism. The table allows the thin-film solar cell to be disposed thereon as a defect repaired target. The head includes the thin-film solar cell defect repairing tool according to any one of the first to third aspects of the present invention. The head is allowed to be moved up and down. The head is configured to drive and rotate the thin-film solar cell defect repairing tool. The moving mechanism is configured to relatively move the table and the head within a horizontal plane.

According to the thin-film solar cell defect repairing device of the fourth aspect of the present invention, the thin-film solar cell is disposed on the table as a defect repaired target. The table and the head are then relatively moved within the horizontal plane for aligning the thin-film solar cell defect repairing tool with the position of the local defect. Under the condition, the thin-film solar cell defect repairing tool is lowered for pressing the blade thereof onto the surface of the substrate of the cell and is then driven and rotated. The thin film is thereby partially removed about the local defect in a ring shape. Accordingly, the local defect can be insulated and isolated from the other part of the thin film.

A thin-film solar cell defect repairing device according to a fifth aspect of the present invention relates to the thin-film solar cell defect repairing device according to the fourth aspect of the present invention. In the thin-film solar cell defect repairing device, the head includes a chuck, a motor, a joint and a pressure mechanism. The chuck holds the thin-film solar cell defect repairing tool. The motor is configured to rotate the chuck. The joint couples the chuck and a rotary shaft of the motor in a non-rotatable and vertically movable state with respect to each other. The pressure mechanism is configured to press the thin-film solar cell defect repairing tool onto a surface of the thin-film solar cell with a predetermined load pressure..

In general, a local defect is caused in a minute region. Therefore, the defect repairing tools are normally formed with a quite narrow size (e.g., a diameter of roughly 1 mm). As is often the case with the drill processing devices, such a quite narrow tool is directly coupled to the motor and the motor and chuck part is lowered for pressing the tool onto the surface of the substrate. In this case, the tool may be bent or damaged due to the weight of the motor and chuck part.

According to the thin-film solar cell defect repairing device of the fifth aspect of the present invention, in view of the above, the chuck and the motor, holding the thin-film solar cell defect repairing tool, are coupled through the joint for preventing the weights of the motor and etc. from acting on the thin-film solar cell defect repairing tool. Therefore, it is possible to inhibit the thin-film solar cell defect repairing tool from being bent or damaged.

A thin-film solar cell defect repairing device according to a sixth aspect of the present invention relates to the thin-film solar cell defect repairing device according to the fifth aspect of the present invention. In the thin-film solar cell defect repairing device, the head further includes a holder and an urging member. The holder supports the chuck in a rotatable state. The urging member upwardly urges the chuck and the holder for cancelling out a weight of the chuck and a weight of the holder.

According to the thin-film solar cell defect repairing device of the sixth aspect of the present invention, not only the weight of the motor but also the weights of the chuck and the holder are prevented from acting on the thin-film solar cell defect repairing tool by means of the urging member. Therefore, it is possible to further inhibit the thin-film solar cell defect repairing tool from being bent or damaged.

A thin-film solar cell defect repairing method according to a seventh aspect of the present invention is a method for insulating and isolating a local defect caused in a thin-film solar cell. The thin-film solar cell defect repairing method includes the following steps of:

(1) preparing a thin-film solar cell defect repairing tool including a blade end with a blade formed at a predetermined width in a position away from a rotary axis of a thin-film solar cell defect repairing tool; and

(2) rotating the thin-film solar cell defect repairing tool for partially removing a thin film of the thin-film solar cell about the local defect in a ring shape.

According to the method of the seventh aspect of the present invention, the local defect is insulated and isolated from the surrounding part thereof Further, an electrode film disposed under the thin film is less exposed through the removed portion of the thin film. Therefore, this can inhibit deterioration of the aesthetic appearance of the thin-film solar cell as much as possible,

### Advantageous Effects of the Invention

Overall, according to the present invention, a local defect caused in the thin-film solar cell can be repaired without deteriorating the aesthetic appearance of the thin-film solar cell.

### BRIEF DESCRIPTION OF THE DRAWINGS

Referring now to the attached drawings which form a part of this original disclosure:

FIG 1 is an external perspective view of a defect repairing device employing an exemplary embodiment of the present invention;

FIG 2 is a side view of a head of the defect repairing device;

FIG 3 includes a front view, a side view and a bottom view of a defect repairing tool according to an exemplary embodiment of the present invention;

FIG.4 is an enlarged view of a part A of the defect repairing tool in the front view of FIG 3; and

FIG 5 is a diagram illustrating an exemplary processing to be executed by the defect repairing tool.

### DETAILED DESCRIPTION OF THE EMBODIMENTS

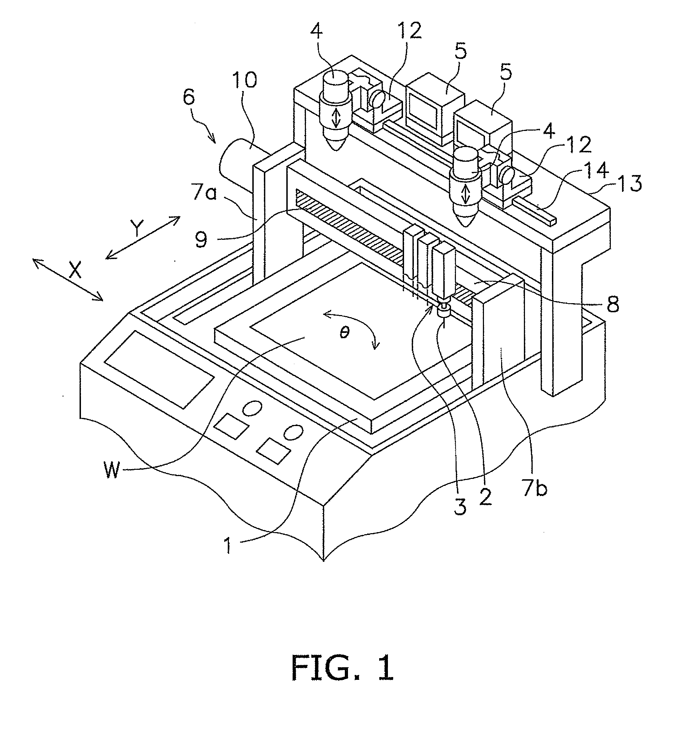

FIG 1 illustrates an external perspective view of a defect repairing device for an integrated thin-film solar cell employing an exemplary embodiment of the present invention.

### (Entire Structure of Defect Repairing Device)

The defect repairing device includes a table 1, a plurality of heads 3, two cameras 4 and two monitors 5. The table 1 is provided for disposing a solar cell substrate W thereon. Each head 3 includes a defect repairing tool 2.

The table 1 is movable in a Y direction within a horizontal plane as depicted in FIG 1. Further, the table 1 is rotatable at an arbitrary angle within the horizontal plane. FIG 1 herein schematically illustrates the appearances of the heads 3 (two of which do not herein include illustration of their tips). In other words, the shapes of the heads 3 herein illustrated are different from the actual shapes of the heads 3. The heads 3 will be explained in detail in the following paragraphs.

A moving support mechanism 6 is configured to move the respective heads 3 in X and Y directions above the table 1. As illustrated in FIG 1, the X direction is perpendicular to the Y direction within the horizontal plane. The moving support mechanism 6 includes a pair of support columns 7a and 7b, a guide bar 8 and a motor 10. The guide bar 8 is disposed between the support columns 7a and 7b. The motor 10 is configured to drive a guide 9 formed on the guide bar 8. Each head 3 is movable along the guide 9 in the X direction as described above. Further, each head 3 is embedded with an air cylinder (not illustrated in the figures) and is thereby entirely movable up and down.

Each camera 4 is fixed onto a base 12. Each base 12 is movable along a guide 14 that is disposed on a support base 13 and extended along the X direction. Each camera 4 is movable up and down and an image recorded by each camera 4 is displayed on the corresponding one of the monitors 5.

### (Head)

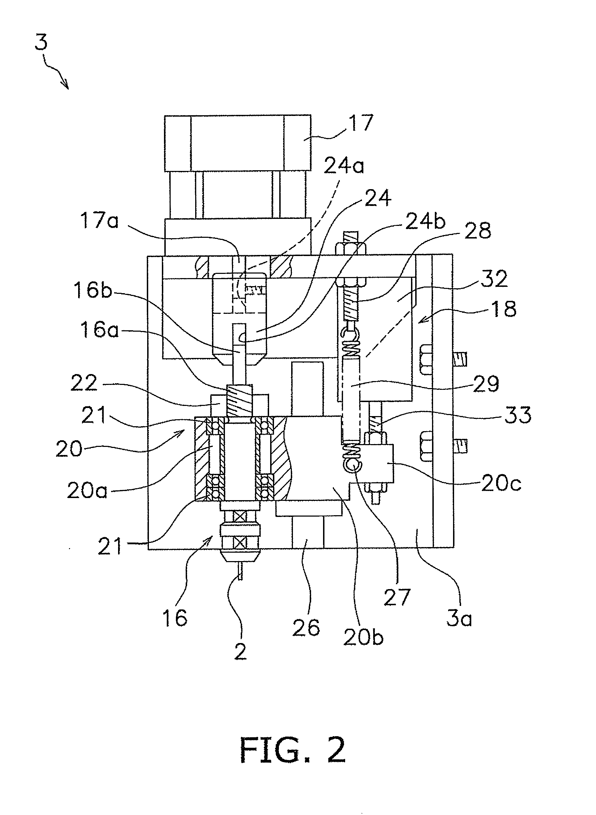

FIG 2 selectively illustrates the main components of each head 3. The main components illustrated in FIG 2 are attached to a moving frame (not illustrated in the figures) configured to move along the guide 9 and are moved up and down by the air cylinder (not illustrated in the figures). It should be noted that FIG 2 is a side view of each head 3 (seen in the X direction of FIG. 1).

Each head 3 includes the defect repairing tool 2. Each head 3 further includes a chuck 16, a motor 17 and a pressure mechanism 18. The chuck 16 holds the defect repairing tool 2. The motor 17 is configured to rotate the chuck 16. The respective members are supported by a head frame 3a fixed to the aforementioned moving frame.

The chuck 16 has a heretofore known structure such as employed for chucks mounted in the well-known drill processing devices and etc. The chuck 16 holds the defect repairing tool 2 for allowing it to be detached therefrom. The chuck 16 is rotatably supported by a holder 20. Specifically, the holder 20 includes a through hole 20a penetrating therethrough up and down. Further, a plurality of bearings 21 is disposed in the upper and lower parts of the through hole 20a. The chunk 16 is rotatably supported by the bearings 21. Yet further, a screw 16a is formed on the upper part of the chuck 16. A bearing nut 22 is screwed onto the screw 16a. The bearing nut 22 is abutted to the inner race of the upper one of the plural bearings 21. The chuck 16 is thus held by the holder 20 with the aforementioned structure. Further, the chuck 16 includes a flat portion 16b for coupling on the upper end thereof

A rotary shaft 17a of the motor 17 and the flat portion 16b of the chuck 16 are coupled by a joint 24. The joint 24, formed in a columnar shape, includes a circular hole 24a on the upper part thereof and includes a slit 24b on the lower part thereof. The hole 24a is upwardly opened, whereas the slit 24b is downwardly opened. The rotary shaft 17a of the motor 17 is inserted into the hole 24a. The rotary shaft 17a is fixed therein while being prevented from rotating and moving up and down. On the other hand, the flat portion 16b of the chuck 16 is inserted into the slit 24b. The flat portion 16b is herein simply inserted into the slit 24b. Therefore, the flat portion 16b is allowed to slide along the slit 24b although it is prevented from rotating with respect to the slit 24b.

Further, the holder 20 includes a guide portion 20b and a pressure coupling portion 20c. The guide portion 20b is extended in a depth direction (i.e., a right direction in FIG 2). The pressure coupling portion 20c is further extended from the guide portion 20b in the depth direction. The head frame 3a is provided with a guide rail 26 extended up and down. The guide portion 20b is slidably engaged with the guide rail 26. Further, the holder 20 is provided with a pin 27. The head frame 3a is provided with a rod 28 disposed above the pin 27. A spring 29 is disposed vertically between the pin 27 and the rod 28. The chuck 16 and the holder 20 are both upwardly urged by the spring 29. The weights of the chuck 16 and the holder 20 are thereby cancelled out.

The pressure mechanism 18 includes an air cylinder 32 fixed to the head frame 3a. A piston rod 33 of the air cylinder 32 is coupled to the pressure coupling portion 20c of the holder 20. Therefore, the holder 20 and the chuck 16 can be elevated and lowered by driving the air cylinder 32.

### (Defect Repairing Tool)

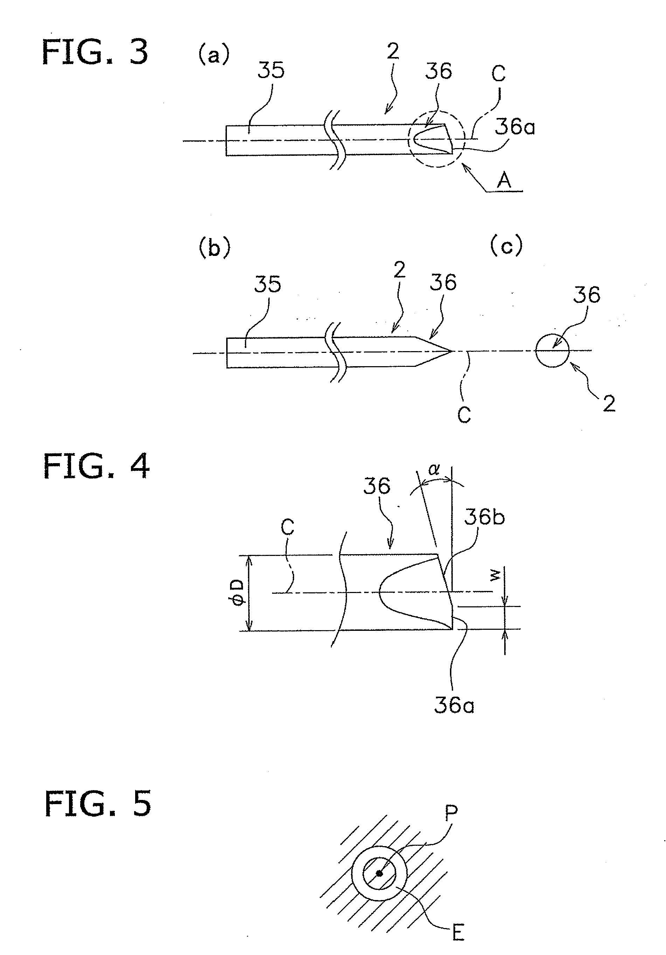

FIG 3 illustrates the defect repairing tool 2. Specifically, FIG 3 includes a front view (a), a side view (b) and a bottom view (c) of the defect repairing tool 2. Further, FIG 4 illustrates a detailed diagram of a part A of the defect repairing tool 2 illustrated in the front view (a) of FIG 3.

As illustrated in FIGS. 3 and 4, the defect repairing tool 2 is a stick-shaped member having a circular cross-section. The defect repairing tool 2 includes a shank 35 on one end thereof while including a blade end 36 on the other end thereof The shank 35 is held by the chuck 16. The blade end 36 includes a blade 36a for processing on the edge thereof The defect repairing tool 2 is configured to be rotated about a rotary axis C while being attached to the chuck 16.

The blade 36a of the blade end 36 is formed perpendicularly to the rotary axis C while being disposed away from the rotary axis C. The other part of the blade end 36, excluding the blade 36a, is a contact avoiding portion 36b prevented from making contact with a processing target. The contact avoiding portion 36b is tilted at a predetermined angle α with respect to the blade 36a. In other words, the contact avoiding portion 36b is tilted at the angle α for getting closer to the shank 35 in proportion to distance away from the blade 36a. In the present exemplary embodiment, a diameter D of the defect repairing tool 2 is set to be 1 mm while a width w of the blade 36a is set to be 0.1 mm. The width w of the blade 36a is herein preferably set to be less than or equal to 0.1 mm and small as much as possible.

### (Defect Repairing Method)

First, a visual inspection is conducted for checking existence of a local defect on a substrate using the cameras 4 and the monitors 5. When a local defect is found, the moving support structure 6 is caused to move a suitable one of the heads 3 for appropriately positioning the rotary axis C of the defect repairing tool 2 immediately above the local defect.

After the aforementioned positioning, the motor 17 is driven for rotating the defect repairing tool 2. The air cylinder 32 is herein driven for lowering the holder 20 and the chuck 16. Accordingly, the tip of the defect repairing tool 2 set in the chuck 16 is pressed onto the thin films of the TFSC. As a result, a ring-shaped film removed portion E is formed about a local defect P as illustrated in FIG 5. The local defect P can be insulated and isolated from the other part of the thin film by forming the film removed portion E.

In this case, the thin films are partially removed about the local defect P in a ring shape without entirely removing a predetermined region of the thin films including the local defect P. Therefore, the lower electrode film (i.e., the Mo film), disposed under the thin films, is less exposed through the removed region. Consequently, a smaller area of the lower electrode film shines in appearance and this inhibited deterioration of the aesthetic appearance of the TFSC.

Further, the chuck 16 and the holder 20, including the defect repairing tool 2, do not receive load from the members on the motor 17 side due to the joint 24. In addition, the weights of the chuck 16 and the holder 20 including the defect repairing tool 2 are cancelled out by the spring 29. In other words, a pressure load set by the air cylinder 32 only acts on the defect repairing tool 2. Therefore, the pressure load of the defect repairing tool 2 can be accurately controlled and set to be requisite minimum with respect to the thin films. Consequently, the defect repairing tool 2 can be inhibited from being bent and damaged by means of an excessive load acting thereon.

### (Other Exemplary Embodiments)

The present invention is not limited to the aforementioned exemplary embodiment and a variety of changes and modifications can be made without departing from the scope of the present invention.

For example, the shape of the blade end of the defect repairing tool is not limited to that in the aforementioned exemplary embodiment. Any suitable shapes can be applied to the blade end as long as the blade end can partially remove the thin films in a position away from the rotary axis C.

Further, the present invention can be applied not only to repairing for defects of the TFSCs using a compound semiconductor but also to repairing for defects of the TFSCs using a semiconductor made of other materials (e.g., the thin-film silicon solar cells).

### Reference Signs List

- 1: Table
- 2: Defect repairing tool
- 3: Head
- 16: Chuck
- 17: Motor
- 18: Pressure mechanism
- 20: Holder
- 24: Joint
- 29: Spring
- 32: Air cylinder
- 35: Shank
- 36: Blade end
- 36a: Blade
- 36b: Contact avoiding portion
A thin-film solar cell defect repairing tool of the present invention is configured to be rotated while being held by a chuck (16) disposed in a head of a processing device for insulating and isolating a local defect caused in a thin-film solar cell. The tool includes a shank (35) and a blade end (36). The shank (35) is formed on an end of the thin-film solar cell and is held by the chuck (16). The blade end (36) is formed on the other end of the thin-film solar cell and includes a blade (36a) for processing on the edge thereof Further, the blade (36a) of the blade end (36) is formed with a predetermined width in a position away from the rotary axis of the tool.

## Claims

1. A thin-film solar cell defect repairing tool configured to be rotated with being held by a chuck disposed in a head of a processing device for insulating and isolating a local defect caused in a thin-film solar cell, comprising:
a shank formed on one end of the thin-film solar cell defect repairing tool, the shank held by the chuck; and
a blade end formed on the other end of the thin-film solar cell defect repairing tool, the blade end including a blade for processing on an edge thereof, the blade formed at a predetermined width in a position away from a rotary axis of the thin-film solar cell defect repairing tool.

2. The thin-film solar cell defect repairing tool recited in claim 1,
wherein the blade of the blade end is arranged perpendicularly to the rotary axis of the thin-film solar cell defect repairing tool, and
the other part of the edge of the blade end excluding the blade is tilted for getting closer to the shank in proportion distance away from the blade.

3. The thin-film solar cell defect repairing tool recited in one of claims 1 and 2, wherein the blade of the blade end has a width of 0.1 mm or less.

4. A thin-film solar cell defect repairing device configured to insulate and isolate a local defect caused in a thin-film solar cell, comprising:
a table allowing the thin-film solar cell to be disposed thereon as a defect repaired target;
a head including the thin-film solar cell defect repairing tool according to any one of claims 1 to 3, the head allowed to be moved up and down, the head configured to drive and rotate the thin-film solar cell defect repairing tool; and
a moving mechanism configured to relatively move the table and the head within a horizontal plane.

5. The thin-film solar cell defect repairing device recited in claim 4, wherein the head includes:
a chuck holding the thin-film solar cell defect repairing tool;
a motor configured to rotate the chuck;
a joint coupling the chuck and a rotary shaft of the motor in a non-rotatable and vertically movable state with respect to each other; and
a pressure mechanism configured to press the thin-film solar cell defect repairing tool onto a surface of the thin-film solar cell with a predetermined load pressure.

6. The thin-film solar cell defect repairing device recited in claim 5, wherein the head further includes:
a holder supporting the chuck in a rotatable state; and
an urging member upwardly urging the chuck and the holder for cancelling out a weight of the chuck and a weight of the holder.

7. A thin-film solar cell defect repairing method for insulating and isolating a local defect caused in a thin-film solar cell, comprising;
preparing a thin-film solar cell defect repairing tool including a blade end with a blade formed at a predetermined width in a position away from a rotary axis of a thin-film solar cell defect repairing tool; and
rotating the thin-film solar cell defect repairing tool for partially removing a thin film of the thin-film solar cell about the local defect in a ring shape.
